# EUROPÄISCHE PATENTSCHRIFT

(11) **EP 0 158 972 B1**
(45) Veröffentlichungstag und Bekanntmachung des Hinweises auf die Patenterteilung: **17.02.1993**
(21) Anmeldenummer: 85104363.8
(22) Anmeldetag: 11.04.1985
(51) Int. Cl.: C23C 14/30, H01J 37/305

(54) **Verfahren und Vorrichtung zur Materialverdampfung in einer Unterdruckkammer durch Bogenentladung**
Method and apparatus for the vaporisation of a material in a vacuum chamber by an arc discharge
Procédé et dispositif pour vaporiser un matériau dans une enceinte sous vide à l'aide d'une décharge d'arc

(30) Priorität: 12.04.1984 DE 3413891
(43) Veröffentlichungstag der Anmeldung: 23.10.1985
(73) Patentinhaber: Plasco Dr. Ehrich Plasma-Coating GmbH, 55262 Heidesheim (DE)
(72) Erfinder: Ehrich, Horst, Dipl.-Phys., Dr., D-4270 Dorsten (DE)
(74) Vertreter: Selting, Günther, Dipl.-Ing.

(56) Entgegenhaltungen:
- FR-A- 822 069
- FR-A- 1 496 697
- FR-A- 2 226 480
- US-A- 3 562 141
- CHEMISTRY AND INDUSTRIE, Nr. 7, 3. April 1976, Seiten 316,317, The Chemical Society, Letch Worth, Herts, GB; A.J. WICKENS: "Formation of boron carbide in a high-intensity arc plasma"
- SOVIET INVENTIONS ILLUSTRATED, Week J 48, veröffentlicht 19. Januar 1983
- IEEE Transactions on Plasma Science, Vol. PS-11, No.2, June 1983, Seiten 76-88

## Beschreibung

Die Erfindung betrifft Verfahren und Vorrichtungen zur Materialbeschichtung, wobei das zu beschichtende Material in einer Unterdruckkammer Materialdampf ausgesetzt wird, der durch Beschuß des zu verdampfenden Materials mit Elektronen aus einer zwischen einer Kathode und einer Anode brennenden Bogenentladung, erzeugt wird wobei Kathode und Anode in der Unterdruckkammer angeordnet sind und das zu verdampfende Material mit der Anode verbunden ist.

In der Literatur sind zahllose Arbeiten über die grundlegenden physikalischen Mechanismen und die praktische Anwendung von Vakuumbogenentladungen zu finden. Eine zusammenfassende Darstellung ist "Vacuum Arcs, Theory and Application, J. M. Lafferty, Editor, John Wiley and Sons (1980) zu entnehmen.

Dieses Dokument beschreibt unter 1.3. auf Seiten 5 - 7 die generellen Charakteristika der Vakuumbogenentladung und der Kathodenflecken, die in einer Kaltkathode vorwiegend bei nicht refraktorischen Metallen auftreten. Die Kathodenflecken bestehen aus einer beträchtlichen Anzahl aktiver Bereiche, die sich über die metallische Oberfläche der Kathode schnell bewegen. In diesen Bereichen treten sehr hohe Stromdichten auf, was zu einer Ablösung von Kathodenmaterial führt mit Dampfströmen von bis zu 1000 m/sec. In diesen Dampfströmen erfolgt die Ionisierung der Metallatome durch Emission von Elektronen.

Vakuumbogenentladungen werden insbesondere zur Herstellung von Überzügen auf Werkstoffen durch Kondensation von Dampf eingesetzt. Dabei befindet sich die Dampfquelle in einem evakuierbaren Gefäß, der Aufdampfanlage, und die zu bedampfenden Gegenstände sind in einigem Abstand so zur Dampfquelle orientiert, daß sich der Dampf auf der gewünschten Oberfläche niederschlägt. Häufig eingesetzt werden Apparaturen, in denen das zu verdampfende Material sich in einem hochschmelzenden Tiegel befindet, der auf unterschiedliche Weise, so z. B. durch Joule-Effekt oder Induktion geheizt wird.

Eine andere Methode beruht auf der Kathodenzerstäubung.

Für die Verdampfung von Material mit Hilfe eines Elektronenstrahls werden Elektronenkanonen mit Glühkathoden angewendet. Bei diesen wird die zur Verdampfung des Materials notwendige Leistungsdichte dadurch erreicht, daß die von der Glühkathode emittierten Elektronen durch eine Hochspannung, z. B. 10 kV, beschleunigt werden. Dabei entsteht ein gebündelter Elektronenstrahl, der oft auf einer unter der Wirkung eines Magnetfeldes gekrümmten Bahn auf das zu verdampfende Material gelenkt wird. Ein Nachteil dieser Verdampfungsmethode liegt in der relativ geringen Anzahl inelastischer Stöße der Strahlelektronen mit dem erzeugten Dampf. Die Wirkungsquerschnitte sind bei hohen Energien klein. Eine Aktivierung des Dampfes durch Dissoziation, Anregung und Ionisation ist aber oft eine wichtige Voraussetzung zur Erzielung qualitativ guter Beschichtungen. Ein weiterer Nachteil ist, daß zumindest in der Elektronenkanone ein sehr gutes Vakuum aufrechterhalten werden muß.

Diese Nachteile führten zur Entwicklung von Elektronenstrahlverdampfern mit geringerer Elektronenenergie bei höherem Elektronenstrom. Bekannt sind z. B. nach C. T. Wan, D. L. Chambers and D. C. Carmichael, The Journal of Vaccum Science and Technologie, Vol. 8, No. 8, p. VM 99, 1971, Elektronenstrahlverdampfer mit heißer und kalter Hohlkathode. In diesen Verdampfern wird das mit der Anode verbundene zu verdampfende Material mit Elektronen beschossen, die in dieser Hohlkathodenentladung erzeugt werden. Allerdings zeigt nur die Entladung mit heißer Hohlkathode eine für die Aktivierung des Dampfes günstige Strom-Spannungs- Charakteristik. Nachteile dieses Elektronenstrahlverdampfers sind, daß die Entladung schwierig zu zünden ist, das Kathodenmaterial zerstäubt wird und den erzeugten Dampf verunreinigt und zur Aufrechterhaltung der Entladung im Verdampfungsraum zwingend ein Brenngas erforderlich ist.

So beschreibt die FR 1496697 eine Bedampfungsvorrichtung, bei der die Elektronen über eine Glühkathode emittiert werden. Die so erzeugten Elektronen werden mit Hilfe eines starken Magnetfeldes beschleunigt und so fokussiert, so daß sie die Verdampfung von auf die Anode gebrachtem Material bewirken. Der dabei erzeugte Lichtbogen bricht beim Abschalten des Magnetfeldes zusammen.

In der deutschen Offenlegungsschrift 28 23 876 (bzw. US-PS 4 197 175) wird ein Verfahren zur Materialverdampfung beschrieben, bei dem ein Elektronen strahl mit Hilfe einer Niedervoltbogenentladung erzeugt wird. Diese Entladung brennt zwischen einer Glühkathode und einer als Tiegel ausgebildeten Anode. Das zu verdampfende Material befindet sich in diesem Tiegel. Die Glühkathode befindet sich in einer separaten Glühkathodenkammer, die durch eine kleine Öffnung mit dem Aufdampfraum verbunden ist. Während des Betriebs der Niedervoltbogenentladung wird der Glühkathodenkammer laufend ein Brenngas zugeführt, das durch die erwähnte Öffnung in den Aufdampfraum strömt. Durch ständiges Auspumpen des Aufdampfraumes wird erreicht, daß in der Glühkathodenkammer ein für den Betrieb des Niedervoltbogens ausreichend hoher Gasdruck herrscht (2 Pa), während im Aufdampfraum ein geringerer Gasdruck vorhanden ist. Der Stromtransport zwischen Anode und Kathode erfolgt durch die erwähnte Öffnung, die gleichzeitig für eine Bündelung des auf die Anode gerichteten Elektronenstrahls sorgt. Unter der Wirkung eines geeigneten Magnetfeldes wird der Elektronenstrahl noch stärker gebündelt und auf das mit der Anode verbundene und zu verdampfende Material gelenkt.

Bei einer Leistungsaufnahme der Niedervoltbogenentladung von ca. 10 kW setzt eine Verdampfung des Anodenmaterials ein.

Wie im Falle der Hohlkathodenentladung ist auch für den Betrieb des Niedervoltbogens die Anwesenheit eines Brenngases im Aufdampfraum zwingend erforderlich. Daher ist mit beiden Verfahren die Herstellung reiner Metalldämpfe nicht möglich. Für Beschichtungen mit reinen Metallen ist die Anwesenheit eines Brenngases oft ein großer Nachteil. Aus diesem Grunde werden sowohl die Hohlkathodenentladung als auch die Niedervoltbogenentladung vorzugsweise für die Herstellung von Beschichtungen eingesetzt, die aus chemischen Reaktionsprodukten von verdampften Material und dem Brenngas bestehen, wie z. B. TiN.

Zur Erzeugung reiner Metalldämpfe im Vakuum ist nach der britischen Patentschrift 1 322 670 ein weiteres Verfahren bekannt. Dieses benutzt die Zerstäubung und Verdampfung von Kathodenmaterial beim Vakuumbogen. In einer Vakuumbogenentladung erfolgt der Stromtransport zwischen zwei anfangs im Vakuum befindlichen Elektroden in dem an der Kathodenoberfläche erzeugten und aus Kathodenmaterial bestehenden ionisierten Dampf. Charakteristisches Merkmal dieser Entladungsform sind die sogenannten Kathodenflecken, dies sind - abhängig von der Strömstärke - ein oder mehrere sehr kleine leuchtende Bereiche, die sich zumeist schnell auf der kalten Kathodenoberfläche bewegen. Praktisch der gesamte Stromtransport erfolgt über die Kathodenflecken, in denen Stromdichten von 10⁵ bis 10⁷ A/cm² beobachtet werden. Diese Energiekonzentration führt zu einer intensiven Ablösung von Kathodenmaterial, und zwar sowohl als ionisierter Dampf als auch in Form von kleinen geschmolzenen Tröpfchen. Es handelt sich hier also um eine Variante der schon erwähnten Kathodenzerstäubung. Die Anode ist in dem beschriebenen Verfahren inaktiv und dient lediglich als Kollektor für die erzeugten Elektronen. Die Beschichtung von Werkstoffen mit Hilfe des in den kathodischen Brennflecken erzeugten Materials bietet jedoch zwei entscheidende Nachteile. So ist zunächst ein solcher Vakuumbogen sehr instabil und kurzlebig (s.J.D. Cobine and G. A. Farrall, Journal of Applied Physics, Vol. 31, No. 12, p. 2296, 1960). Erst bei hohen Stromstärken von einigen hundert Ampere wird eine zum stationären Betrieb geeignete Stabilität dieser Vakuumbogenentladung erreicht. Daher sind zur Erzielung ausreichend dicker Beschichtungen entweder hohe Stromstärken oder häufige Wiederzündungen des Vakuumbogens notwendig (A.S. Gilmour Jr. and D. L. Lockwood, Proceedings of the IEEE, Vol. 60, No. 8, p.977, 1972). Ein weiterer Nachteil ist, daß ein wesentlicher Teil des zerstäubten Materials die Kathodenflecke mit hoher Geschwindigkeit als geschmolzene Tröpfchen verläßt. Dieses Spritzen führt zu unregelmäßigen und qualitativ minderwertigen, z. B. löchrigen Beschichtungen.

Zusammenfassend kann zum Stand der Technik dargelegt werden, daß der bekannte Vakuumbogen durch die kathodischen Brennflecke charakterisiert ist, die sowohl das Brennmedium als auch die Elektronen für die Entladung liefern. Im allgemeinen führt die rasche Kondensation des Dampfes an den Gefäßwänden zu einem Mangel an Ladungsträgern in der Entladungsstrecke. Hierdurch wird der Vakuumbogen instabil und verlöscht sehr leicht. Diese Eigenschaft wird als Unterbrecher-Schalter in Wechselstromkreisen ausgenutzt und diese Anwendung steht überwiegend im Vordergrund aller Veröffentlichungen über Vakuumbögen. Diese sind dabei konstruktiv so ausgelegt, daß die Anode möglichst nur inaktiv als Elektronenkollektor wirkt. Verdampfungen an der Anode sind unerwünscht, da sie zum Versagen der Schalteigenschaften führen können. Aus diesem Grunde sind aus der Literatur erst anodische Verdampfungen bei Vakuumbögen bei extrem hohen Stromstärken von mehr als 2000 A bekannt (H. C. Miller, IEEE Transactions on Plasma Science, Vol. PS-11, No. 2, p. 76, 1983).

Bei dem bekannten Vakuumbogen ist nur die Kathode aktiv, die Erzeugung des zum Erhalt der Entladung notwendigen Materialdampfes findet überwiegend in den Kathodenflecken dieser Entladung statt. Die Anode ist inaktiv und dient lediglich als Kollektor für Elektronen und Material aus der Entladung. Wegen der raschen Kondensation des in den Kathodenflecken erzeugten Materials an den Wänden sowie einer ungenügenden Erneuerung dieses Materials ist dieser Entladungstyp bei Stromstärken unter einigen hundert Ampere sehr kurzlebig und instabil.

In den weit verbreiteten Elektronenstrahlverdampfern wird der Elektronenstrahl mittels einer Glühkathode erzeugt, durch eine Hochspannung beschleunigt und mit Hilfe eines Magnetfeldes auf das zu verdampfende Material fokussiert.

Zwei andere Verfahren benutzen zur Erzeugung der Elektronen Gasentladungen mit heißer Kathode, die die schon genannte Hohlkathodenentladung und die Niedervoltbogenentladung darstellen. Das für die Ausführung beider Verfahren zwingend erforderliche, der Entladung zuzuführende Brenngas (z.B. N₂ oder Argon) dient dem Zweck, die von der heißen Kathode emittierten Elektronen in einer Gasentladung zu vervielfachen und damit eine weitaus stärkere Aufheizung der Anode zu erreichen. Im Aufdampfraum liegt daher stets eine Mischung aus Anodendampf und Brenngas vor, die Erzeugung z. B. eines reinen Metalldampfes ist mit diesen Verfahren nicht möglich.

Das Dokument Chemistry and Industry, 7, 1976, S. 316 beschreibt eine Vorrichtung zur Herstellung von pulverförmigem Borcarbid, wobei in einem Messingreaktor eine Kathode und eine Anode angeordnet sind. Die Vorrichtung verfügt über eine Kathode aus massivem Graphit.

Bei bisherigen Verfahren und Vorrichtungen zur Materialverdampfung in einer Unterdruckkammer durch Beschuß des zu verdampfenden Materials mit Elektronen aus einer zwischen einer Kathode und einer Anode brennenden Bogenentladung ist zur Fokussierung des Elektronenstrahls auf die Anode ein teilweise beträchtliches Magnetfeld erforderlich, weil ohne Magnetfeld auf dem Anodenmaterial eine zur Verdampfung notwendige Leistungsdichte nicht erreicht wird. Der Leistungsbedarf dieser Verfahren liegt typischerweise bei ca. 10 kW.

Bei dem bisher für Verdampfungszwecke eingesetzten kathodischen Vakuumbogen wird bei hohen Stromstärken (z.B. 300 A) nur die Materialabtragung an der Kathode ausgenutzt, die Anode ist inaktiv. Diese Materialabtragung ist eine Variante der schon lange bekannten Kathodenzerstäubung.

Die vorliegende Erfindung geht von der Aufgabe aus, eine Beschichtung mittels Elektronenstrahlverdampfung mit einfachen Mitteln bei geringem Energieaufwand ohne Anwendung eines Brenngases und eines Magnetfeldes durchzuführen.

Diese Aufgabe wir dadurch gelöst, daß
a) die Elektronen zum Erhalt einer Vakuumbogenentladung zwischen der Kathode und der Anode in den Kathodenflecken auf der Oberfläche besagter Kathode entstehen,
b) die in dieser Vakuumbogenentladung erzeugten Elektronen die Anode oder einen Teil derselben so stark verdampfen, daß die Vakuumbogenentladung im wesentlichen durch das verdampfte Anodenmaterial als Brennmedium aufrechterhalten wird,
c) die in besagter Vakuumbogenentladung erzeugten Elektronen sich selbsttätig ohne Anwendung äußerer Magnetfelder auf der Anode fokussieren.

Die vorliegende Erfindung basiert auf der Entwicklung eines neuen Typs des Vakuumbogens, der anodisch bestimmten Vakuumbogenentladung bei kleinen Stromstärken.

Nach der Erfindung wird eine Materialverdampfung in einer Unterdruckkammer unter Verwendung zweier gegenüberliegender kalter Elektroden vorgeschlagen, wobei die von den Brennflecken an der Stirnfläche der Kathode ausgehenden Elektronen die Anode oder einen Teil der Anode aufheizen, diese zur Verdampfung bringen und der dabei entstehende Dampf für Materialbeschichtung verwendet wird.

Der der vorliegenden Erfindung zugrundeliegende anodisch bestimmte Vakuumbogen wird infolge starker Verdampfung an der Anode stabilisiert. Diese anodische Verdampfung findet in konzentrierten Bereichen an der Anode statt. Diese Fleckbildung tritt selbsttätig, d. h. ohne eine äußere Beeinflussung, z. B. durch ein Magnetfeld auf, und führt zu einer stürmischen Verdampfung von hoch aktiviertem Anodenmaterial. Die physikalischen Gründe für diese Anodenfleckbildung sind bisher unbekannt. Bei geeigneter Anodenkonstruktion wird an der Anode wesentlich mehr Material verdampft als an der Kathode. Daher brennt diese neu entwickelte Vakuumbogenentladung so lange stabil, wie verdampfbares Material an der Anode bereitgestellt wird. Bei geeigneter Konstruktion und Dimensionierung der Elektroden kann die anodisch bestimmte Vakuumbogenentladung schon mit geringen Stromstärken zwischen 10 und 40 A - abhängig von der zu verdampfenden Materialart - betrieben werden. Dabei benötigt die Entladung eine Spannung von ca. 35 V.

Das erfindungsgemäße Verfahren benutzt zur Materialverdampfung die in einer anodisch bestimmten Vakuumbogenentladung erzeugten Elektronen. Charakteristisches Merkmal dieses Entladungstyps sind die Kathodenflecke auf der kalten Kathode. Im Gegensatz zu den Heißkathoden ist diese Kathode praktisch unzerstörbar. Der während des Bogenbetriebs erzeugte Anodendampf hat zwei Funktionen, einmal liefert dieser das Brennmedium zum Erhalt der Bogenentladung, andererseits kann der Dampf auch für vielfältige Anwendungen genutzt werden, die nachfolgend noch angegeben werden.

Der anodisch bestimmte Vakuumbogen brennt somit z. B. in reinem Metalldampf. Im Gegensatz zu den auf anderen Bogenentladungen basierenden Verfahren ist ein Gasatmosphäre nicht notwendig. Wohl aber ist der Betrieb des anodisch bestimmten Vakuumbogens in einer verdünnten Gasatmosphäre möglich.

Weiterhin ist bei der vorliegenden Erfindung die Fokussierung der Elektronen auf die Anode mittels eines Magnetfeldes nicht notwendig. Vielmehr geschieht diese Fokussierung selbsttätig ohne äußere Maßnahmen.

Der typische Leistungsbedarf des erfindungsgemäßen Verfahrens liegt bei ca. 1kW, also bei 1/10 des Leistungsbedarfs der bekannten Verfahren. Auch ist keine Kathodenheizung erforderlich.

Der nach der Erfindung lediglich geringe Leistungsbedarf in Verbindung mit den kurzen Beschichtungszeiten setzt die thermische Belastung der beschichteten Substrate drastisch herab. Somit ist das erfindungsgemäße Verfahren auch zur Beschichtung von sehr temperaturempfindlichen Materialien geeignet.

Die erfindungsgemäße Lösung wird zur Materialbeschichtung verwendet, auf die nachfolgend im einzelnen eingegangen wird.

Da die nach der vorliegenden Erfindung verdampfende Anode aus unterschiedlichen Materialien herstellbar ist oder zum Zwecke der Verdampfung mit unterschiedlichen Materialien belegt oder bestückt sein kann, lassen sich entsprechend unterschiedliche Materialien verdampfen. So können diese Materialien aus Metall bestehen. Sie können aber auch aus Nichtmetallen bestehen.

Da, wie vorerwähnt, die Anode aus verschiedenartigen Werkstoffen bestehen kann oder mit solchen belegt sein kann, können auch Objekte unterschiedlichen Materials durch Bedampfung beschichtet werden. So können diese Objekte aus einem Metall oder Nichtmetall bestehen. Mit der erfindungsgemäßen Lösung ist es nicht nur möglich, Kunststoffe oder Kunststoffolien verschiedener Arten, wie beispielsweise PVC, Nylon, Polystyrol, Plexiglas oder Polyäthylen durch Aufdampfen mit einer Metallschicht zu versehen, sondern selbst Materialien mit geringem Schmelzpunkt lassen sich mit einer Metallbeschichtung versehen. Eine äußerst geringe thermische Belastung der zu bedampfenden Substrate konnte durch die metallische Beschichtung einer Wachskerze demonstriert werden, die den Beschichtungsprozeß ohne sichtbares Anschmelzen der Oberfläche überstand.

Für viele Anwendungen ausreichend dicke Beschichtungen von 0,05 bis 1 µm sind in Beschichtungszeiten zwischen 10 und 100 sec. zu erzielen.

Besonders vorteilhaft besteht auch die Kathode aus dem zu verdampfenden Material, mit dem die Anode belegt oder bestückt ist.

Die erfindungsgemäße Lösung macht es möglich, daß durch eine geeignete Ausbildung der Elektroden des Vakuumbogens, insbesondere der Anode, die anodische Verdampfung bei geringen Stromstärken, so z.B. 10 A, erfolgen kann. Die nach der Erfindung erfolgende Verdampfung der Anode sorgt dabei für eine ausgezeichnete Stabilität und ermöglicht damit den selbsterhaltenden oder in anderen Worten stationären Betrieb des Vakuumbogens.

Bei dem erfindungsgemäßen Verfahren kann die Zündung des Bogens auf vielfache Weise erfolgen. So können die Kathode und Anode kurzfristig berührt werden. Es kann aber auch eine Hilfselektrode als Zündelektrode verwendet werden. Dabei kann es sich um eine Kathode oder auch eine Anode handeln, die dann mit der entsprechenden Gegenelektrode kurzfristig in Kontakt gebracht wird. Zur Zündung des Bogens kann aber auch in den Raum zwischen Anode und Kathode ein Plasma eingebracht werden. Auch kann die Zündung des Bogens über eine Gasentladung vorgenommen und der Obergang zum Vakuumbogen durch Abpumpen des Gases herbeigeführt werden.

In weiterer erfindungsgemäßer Ausgestaltung wird vorgeschlagen, daß der Anode während des Betriebes verdampfbares Material zugeführt wird, so daß die Anode erhalten bleibt, weil das der Anode zugeführte bzw. von ihr gehaltene bzw. getragene Material verdampft.

Die erfindungsgemäße Lösung macht es möglich, während der Verdampfung die Verdampfungsrate durch Veränderung der Stromstärke zu variieren. Weiterhin kann gleichzeitig aus mehreren Verdampfungsquellen unter unterschiedlichen elektrischen Bedingungen verdampft werden. Es kann auch nacheinander mit zeitlicher Überschneidung aus mehreren Verdampfungsquellen unter unterschiedlichen elektrischen Bedingungen verdampft werden. Auch können Anode und Kathode gegenüber dem Vakuumgefäß auf ein unterschiedliches und veränderbares elektrisches Potential gebracht werden. Schließlich ist es möglich, daß die zu bedampfenden Substrate auf veränderbarem elektrischen Potential gegenüber dem Vakuumgefäß und den Elektroden gehalten werden.

Die erfindungsgemäße Lösung läßt es auch zu, daß während der Verdampfung die Anode relativ zur Kathode bzw. dem Vakuumgefäß bewegt und dadurch die Bedampfung beeinflußt wird.

Eine erfindungsgemäße Vorrichtung zur Bedampfung eines Objektes besteht aus einem Stahlzylinder (11) mit Boden (12) und Deckel (13), wobei der Behälter über einen Ausgang (15) an eine Vakuumpumpe angeschlossen ist, über eine Zündeinrichtung verfügt und in dem Behälter gegenüberliegend eine stromführende kalte Kathode (17) und eine stromführende kalte hohl ausgebildete Anode (21) angeordnet sind, wobei die Anode mit dem zu verdampfenden Material belegt wird und das zu bedampfende Objekt (37) innerhalb des Behälters im Bereich der Anode (21) und im Bereich der Kathode (17) angeordnet ist. Die Vorrichtung ist dadurch gekennzeichnet, daß
a) der in den Behälter hineinragende Teil der Kathode (17) von einem Schutzschild (20) umgeben ist, das an der Behälterwandung (11 a) angeordnet ist;
b) daß die Kathode (17) hohl ausgebildet ist und an ihrem stirnseitigen Ende über ein angeschraubtes Kathodenteil (17) verfügt mit einer Stirnfläche (30), die der Anode zugewandt ist;
c) daß die Kathode mit einer zugeordneten Kühlmittelzuflußleitung und Abflußleitung versehen ist, so daß die Stirnfläche ausreichend gekühlt werden kann.

In weiterer erfindungsgemäßer Ausgestaltung ist innerhalb des Behälters ein Vakuum bzw. ein Unterdruck von mindestens 10⁻¹, vorzugsweise von 10⁻¹ bis 10⁻² Pa vorhanden.

Weiterhin wird vorgeschlagen, daß beide Elektroden an ein Versorgungsgerät angeschlossen sind, das bei einer Brennspannung des Bogens von ca. 35 V einen Strom von mindestens 10 bis 40 A liefert. Ein weiterer erfindungsgemäßer Vorschlag geht dahin, daß zur Zündung des Bogens die Kathode und / oder Anode relativ zueinander verschiebbar gelagert sind oder zur Zündung des Bogens eine der beiden Elektroden eine vorzugsweise verschiebbare Zündelektrode zugeordnet ist. Auch kann zur Zündung des Bogens in dem Bereich zwischen Anode und Kathode eine Vorrichtung zur Zündung durch Plasmabeschuß (Gleitfunken) zugeordnet sein.

In weiterer erfindungsgemäßer Ausgestaltung wird vorgeschlagen, daß zum sicheren Einleiten der anodischen Verdampfung bei der Bogenzündung dem Versorgungsstrom ein kurzer Stromimpuls von mindestens 100 A überlagert wird.

In weiterer erfindungsgemäßer Ausgestaltung sind die Kathode und die Anode mit einer jeweils zugeordneten Kühlmittelzuflußleitung und Kühlmittelabflußleitung versehen.

Die Verdampfung der Anode oder eines Teils der Anode kann auf verschiedene Weise erfolgen. So wird in weiterer erfindungsgemäßer Ausgestaltung vorgeschlagen, daß die durch ein Kühlmittel gekühlte Anode an ihrem zur Kathode weisenden Ende mit einer Verlängerung aus einem hochschmelzenden Material versehen ist, das mit dem zu verdampfenden Material belegt ist.

Ein weiterer Vorschlag geht dahin, daß das zu verdampfende Material an der Anode nachschiebbar ist. Besonders vorteilhaft ist die Lösung, daß innerhalb der gekühlten Anode ein Hohlstab angeordnet ist, in dem das zu verdampfende nachschiebbare Material angeordnet ist.

Um eine Beeinflussung des zu bedampfenden Objektes durch Kathodenmaterial zu vermeiden, ist die Kathode mit einer sie umgebenden Abschirmung versehen, die eine Bedampfung von Partikeln der Kathode an dem von der Anode zu bedampfenden Objekt verhindert. Diese Lösung ist besonders vorteilhaft, sofern die Kathode und der nicht zu verdampfende Teil der Anode nicht aus dem gleichen Material bestehen.

Ein weiterer Vorschlag geht dahin, daß der Raum zwischen der Anordnung des zu bedampfenden Objektes und den die Bedampfung herbeiführenden Elektroden durch eine bewegbare Wandung absperrbar ist.

Ein weiterer Vorschlag besteht darin, daß im Bereich des zu bedampfenden Objektes in der Wandung des Vakuum-Behälters gegenüberliegende Elektroden für eine Glimmentladung vorhanden sind.

Weiterhin wird vorgeschlagen, daß der Objekthalter und damit das zu bedampfende Objekt als Kathode einer während der Verdampfung entstehenden Gasentladung geschaltet sind.

Der Vakuumbehälter kann verschiedene Raumformen haben, die der Anwendung entsprechend dimensioniert oder angepaßt sind.

Um im Falle einer besonderen Anwendung Bohrungen oder Rohrleitungen mit einer Bedampfungsschicht zu belegen, wird in weiterer erfindungsgemäßer Ausgestaltung vorgeschlagen, daß zwei miteinander verbundene Ringscheiben vorhanden sind, die an ihrem Außenumfang mit einer umlaufenden Abdichtung versehen sind und an der Innenwandung der einen Scheibe die Kathode und an der gegenüberliegenden Innenwandung der anderen Scheibe die Anode vorhanden ist. Weiterhin ist eine Scheibe mit einem Schlauch für die Erzeugung des Unterdrucks zwischen den beiden Scheiben und dem elektrischen Kabel zur Stromversorgung der beiden Elektroden versehen.

Besonders vorteilhaft ist eine Lösung, daß bei einem zylindrischen Behälter die koaxial gegenüberliegenden Elektroden jeweils im Boden und Deckel des Unterdruckbehälters angeordnet sind. Dazu wird in weiterer Ausbildung vorgeschlagen, daß in dem Vakuumbehälter ein herausnehmbarer Einsatz vorhanden ist, an dessen ringsumlaufender inneren Fläche die zu bedampfenden Objekte angeordnet sind.

In weiterer erfindungsgemäßer Ausgestaltung können in einem Vakuumbehälter mehrere Paare von Kathoden mit gegenüberliegenden Anoden angeordnet sein. Auch ist der Betrieb mehrerer Anoden mit einer Kathode möglich.

Ein weiterer Vorschlag, der insbesondere zur Bedampfung von Folien, insbesondere aus Kunststoff, dient, besteht darin, daß in einem Vakuumbehälter von im Querschnitt rechteckiger Ausbildung in der einen Seitenwand die Kathode und in der anderen Seitenwand die Anode angeordnet ist und in der einen Stirnwandung der Eingang und in der gegenüberliegenden anderen Stirnwandung der Ausgang der durch Bedampfung zu beschichtenden Folie angeordnet ist. Diese Lösung läßt zu, daß eine zu bedampfende Folie oberhalb und eine andere zu bedampfende Folie unterhalb des Elektrodenpaares angeordnet ist. Diese Lösung läßt in vorteilhafter Weise zu, daß in Bewegungsrichtung der Folienbahn oder der Folienbahnen hintereinander mehrere Elektrodenpaare aus Kathoden und Anoden angeordnet sind.

Die erfindungsgemäße Lösung läßt sich zusammenfassend durch folgende Merkmale charakterisieren:
- Geringe Leistungsaufnahme bei hoher Verdampfungsrate,
- Geringe thermische Belastung der zu bedampfenden Objekte,
- Die erzeugten Beschichtungen sind sehr haftfähig, gleichmäßig und nicht löchrig,
- Einfache und wirtschaftliche Realisierbarkeit,
- Es sind keine externen Maßnahmen notwendig zur Fokussierung der Elektronen auf einen Anodenfleck,
- Das verdampfte Material ist hoch aktiviert,
- Beschichtungsprozesse sind im Hochvakuum ebenso möglich wie in einer Gasatmosphäre,
- Die Abmessungen der Verdampfungsquelle sind klein. Daher ist diese beweglich und ermöglicht z. B. die Innenbeschichtung von Rohren.
- Durch den gleichzeitigen Betrieb mehrerer Verdampfungsquellen mit unterschiedlichen Materialien können z. B. Beschichtungen aus Legierungen hergestellt werden.
- Durch den zeitlich aufeinanderfolgenden Betrieb mehrerer unterschiedlicher Verdampfungsquellen können Beschichtungen mit einer Schichtstruktur hergestellt werden.

Die Erfindung ist in den Zeichnungen beispielhaft dargestellt.
Es zeigen:
- Figur 1: einen vertikalen Schnitt durch eine Vorrichtung für die Bedampfung eines Objektes,
- Figur 2: die Vorrichtung nach Figur 1 in der Ansicht von oben,
- Figur 3: eine Figur 1 gegenüber im Hinblick auf die Zündung abgewandelte Vorrichtung,
- Figur 4: in vertikalem Schnitt und teilweiser Darstellung die Kathode und Anode,
- Figur 4 A: eine abgewandelte Anode,
- Figur 5: eine abgewandelte Anode in vertikalem Schnitt,
- Figur 6: eine weiterhin abgewandelte Anode im vertikalen Schnitt,
- Figur 7: eine Vorrichtung zum Bedampfen der Innenmantelfläche eines Rohres,
- Figur 8: einen vertikalen Schnitt durch eine weitere Bedampfungsvorrichtung,
- Figur 9: die Vorrichtung nach Figur 8 in der Ansicht von oben,
- Figur 10: einen vertikalen Schnitt durch eine weitere Bedampfungsvorrichtung,
- Figur 11: einen vertikalen Schnitt durch eine weitere Bedampfungsvorrichtung,
- Figur 12: die Vorrichtung nach Figur 11 in der Ansicht von oben.

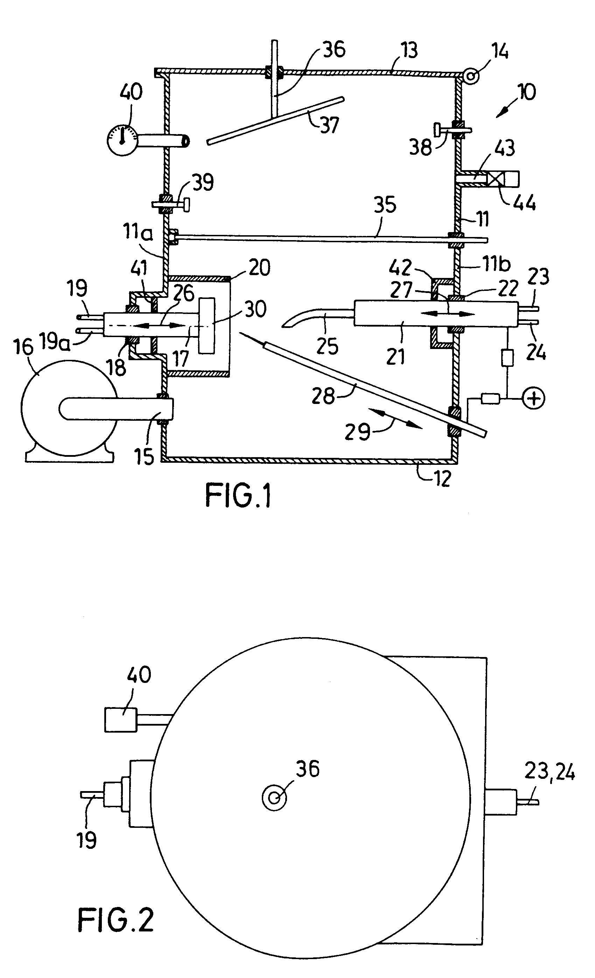

Figur 1 zeigt eine Bedampfungsvorrichtung 10, die aus dem Stahlzylinder 11 besteht, an dem der Boden 12 angeordnet ist. Dieser Behälter ist oben abgeschlossen durch einen Deckel 13, der um ein Scharnier 14 aufklappbar ist. In den Behälter 11 mündet eine Leitung 15, die von einer Vakuumpumpe 16 ausgeht und den Behälter 11 auf einen Unterdruck von 10⁻¹ bis 10⁻² Pa bringt. In der Wandung 11a ist die Kathode 17 angeordnet. Diese ist durch eine umlaufende Isolation 18 gegen die Behälterwandung 11 abisoliert. Neben einer elektrischen Zuleitung hat sie eine Kühlmittelzuflußleitung 19 und Kühlmittelabflußleitung 19a Der in den Behälter hineinragende Teil der Kathode 17 ist umgeben von einem Schutzschild 20 , das an der Behälterwandung 11a befestigt ist. Gegenüberliegend ist in der Wandung 11b die Anode 21 vorhanden, die durch eine diese umgebende Isolation 22 gegen die Behälterwandung 11b elektrisch isoliert ist. Sie hat einen Kühlmittelzufluß 23 und einen Kühlmittelabfluß 24. Die Anode 21 hat an ihrem zur Kathode 17 gerichteten Ende einen verlängerten Teil 25, der mit dem zu verdampfenden Material belegt wird oder der das zu verdampfende Material darstellt.

Zur Zündung ist die Kathode 17 in angegebener Doppelpfeilrichtung 26 und/oder die Anode 21 in angegebener Doppelpfeilrichtung 27 so weit verschiebbar, daß die beiden Elektroden einander berühren. Vorteilhaft sind beide Elektroden in ihrer Achsrichtung verschiebbar gelagert, weil auch zum Zwecke der Verdampfung der Abstand zwischen Kathode und Anode veränderlich sein soll.

Figur 1 zeigt eine Zündelektrode 28 in Gestalt einer Hilfsanode, die in angegebener Doppelpfeilrichtung 29 verschiebbar ist. Zur Zündung wird sie soweit nach innen vorgeschoben, daS die Spitze die Stirnfläche 30 der Kathode berührt.

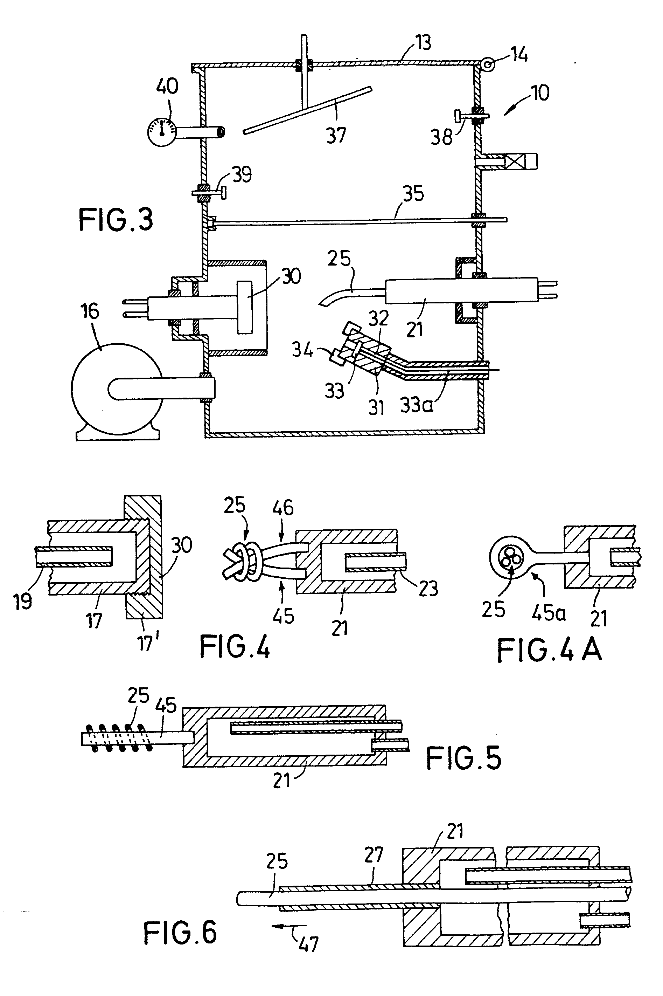

Figur 3 zeigt die Lösung, daß anstelle der Hilfsanode 28 die Zündung über eine Kapillarentladung erfolgt. Vorhanden ist dazu ein Kunststoffzylinder 31 mit mittlerer durchgehender Bohrung 32 und im Inneren vorhandene Elektrode 33, die mit dem elektrischen Anschlußteil 33a versehen ist. Weiterhin ist eine als Elektrode ausgebildete Schraubkappe 34 mit mittiger Bohrung vorhanden. Ein Hochspannungsimpuls von 20 bis 30 kV führt zur Verdampfung des Kunststoffes. Dadurch entsteht das vorerwähnte Plasma.

Oberhalb der beiden Elektroden 17 und 21 ist, absperrbar durch eine Schieberplatte 35, der Aufdampfraum, in dem über eine Haltestange 36 das zu bedampfende Objekt 37 angeordnet ist. In der Wandung 11b ist, gegen diese elektrisch abisoliert, eine erste Elektrode 38 und in der gegenüberliegenden Wandung eine zweite Elektrode 39 für eine Glimmentladung vorhanden. Mit 40 ist ein Vakuummeßgerät bezeichnet.

Mit der Zündung des Vakuumbogens erscheinen auf der Kathode die charakteristischen Brennflecke. Die anodische Verdampfung beginnt dann zumeist innerhalb einer Sekunde. Es ist empfehlenswert, den Vakuumbogen bis zum Einsatz der anodischen Verdampfung durch einen hohen Strom von mehr als 100 A zu stabilisieren. Dabei schmilzt z.B.der in Fig.4 dargestellte Draht 25 zu einem zwischen den beiden glühenden Stäben 45 und 46 hängenden Tropfen. Die Form der Stäbe 45 u.46 sorgt dabei für eine Fixierung der Schmelze am vorderen Anodenende.

Der anodische Ansatz des Vakuumbogens erfolgt als Anodenfleck auf der Schmelze. Dieser ist ein dem kathodischen Brennfleck vergleichbares Phänomen: Der Stromtransport zur Anode konzentriert sich in einem sich langsam über die Schmelze bewegenden Brennfleck von ca. 10 mm² Querschnitt. Seltener sind mehrere Brennflecke. Infolge der großen Leistungsdichte erfolgt hier eine stürmische Verdampfung des Materials bei gleichzeitiger Anregung und Ionisation. Das verdampfte Material verläßt daher die Anode als Plasmastrahl.

Mit der in Figur 1 dargestellten Anordnung werden 5 bis 10 cm von der Anode entfernt angebrachte Gegenstände innerhalb weniger Sekunden mit einer gleichmäßigen, spiegelnden und gut haftenden Metallschicht überzogen. Bei entsprechend längerer Bedampfungszeit können aber auch Objekte in weit größerem Abstand von der Anode (z.B.1m) beschichtet werden. Sobald bei entsprechendem Unterdruck und Zündung die Verdampfung des Anodenteils 25 einsetzt, wird der Schieber 35 aus dem Behältnis soweit herausgezogen, daß die Dampfstrahlen das Objekt 37 bedampfen können. Da der vom Anodenteil 25 ausgehende Dampf in allen Richtungen ausströmt, ist, um eine elektrische Isolation der Elektroden zu der Behälterwandung zu gewahrleisten, die Elektrode 17 mit einer Abdichtung 41 und die Elektrode 21 mit einer Abdichtung 42 versehen.

In den Bedampfungsraum mündet auch eine Leitung 43 für einen Gaseinlaß. Dieser ist mit einem Regelventil 44 versehen.

Figur 4 zeigt in größerer Darstellung die hohl ausgebildete Kathode 17 mit dem angeschraubten Kathodenteil 17', an dessen Stirnfläche 30 die vorerwähnten Brennflecke entstehen. Durch die Leitung 19 strömt ein Kühlmittel, insbesondere Wasser, ein, so daß die Kathode gekühlt ist. Auch die Anode 21 ist hohl ausgebildet. Sie hat die vorerwähnte Kühlmittelzuflußleitung 23. An ihrer Stirnseite sind zwei Halterungen in Gestalt von Stäben 45 und 46 vorhanden, an denen in Gestalt einer Umwicklung das zu vergasende Material 25 angeordnet ist. Es ist verständlich, daß die Stäbe 45 und 46 einen Schmelzpunkt haben, der bedeutend höher liegt als der des zu verdampfenden Materials 25. So bestehen beispielsweise die Stäbe 45 und 46 bei einem Durchmesser von beispielsweise 2 mm aus Wolfram. Die Anode kann auch als Tiegel 45a ausgebildet werden, der das zu verdampfende Material 25 aufnimmt. Die Kathode bzw. deren zur Anode gerichteter Teil besteht aus Metall oder Kohle eines Durchmessers von z.B.2 bis 3 cm. Das zu verdampfende Material 25 besteht aus einem Draht einer Dicke von 1 bis 2 mm, zum Beispiel Aluminium oder Titan. Die Materialien von Anodenhalterung und zu verdampfendem Material sind vorteilhaft so zu wählen, daß beim Betrieb des Vakuumbogens die Schmelze des zu verdampfenden Materials die Anodenhalterung benetzt und die so in Berührung befindlichen Materialien nicht oder nur langsam chemisch miteinander reagieren, z. B. zu Legierungen.

Die flüssigkeitsgekühlten Elektrodenhalterungen für die Anode und die Kathode dienen gleichzeitig zur Herstellung der elektrischen Verbindung zu einem für den Betrieb des Vakuumbogens geeigneten elektrischen Versorgungsgerät. Für die hier beispielsweise angegebene Dimensionierung der Elektroden ist ein Strom von mindestens 10 bis 40 A bei einem Spannungsbedarf des Vakuumbogens von ca. 35 V erforderlich. Bei einem kurzzeitigen und nicht zu häufig wiederholtem Betrieb kann auf eine externe Kühlung verzichtet werden, da bei entsprechender Auslegung der Elektroden und deren Zuleitungen deren Wärmeaufnahme zur Kühlung ausreicht.

Figur 5 zeigt eine Anode 21 abgewandelter Ausbildung mit der Maßgabe, daß nur ein Haltestab 45 vorhanden ist, der von dem zu verdampfenden Material 25 umgeben ist.

Figur 6 zeigt die Lösung, daß die ebenfalls gekühlte Anode 21 an ihrem vorderen Ende ein Röhrchen 27 aus einem hochschmelzenden Material hat, in dem das zu verdampfende Material 25 in Gestalt eines in angegebener Pfeilrichtung 47 nachschiebbaren Drahtes angeordnet ist. Bei dieser Lösung wird somit der Draht 25 als Teil der Anode entsprechend dem Verbrauch vorgeschoben.

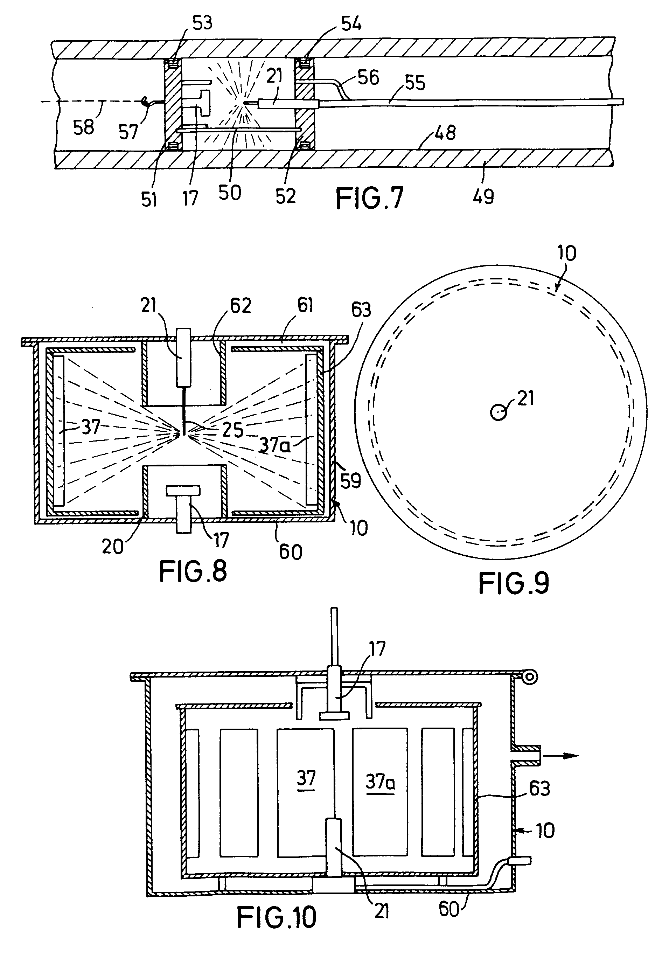

Figur 7 zeigt die Vorrichtung zur Bedampfung der Innenfläche 48 eines Rohres 49. Vorhanden sind die beiden, durch eine Stange 50 oder mehrerer solcher Stangen verbundenen Scheiben 51, 52, die an ihrem Außenumfang mit einer umlaufenden Dichtung 53, 54 versehen sind. An der Scheibe 51 ist die Kathode 17, an der gegenüberliegenden Scheibe ist die Anode 21 vorhanden. An der Scheibe 52 ist, vorteilhaft als bauliche Einheit, eine Leitung 55 vorhanden, die den Schlauch 56 für die Erzeugung des Unterdrucks in dem Raum zwischen den beiden Scheiben und Kühlleitungen sowie die elektrischen Leitungen aufnimmt. Diese können über die dann vorteilhaft hohl ausgebildete Verbindungsstange 50 auch zu der Kathode tragenden Scheibe 51 geführt werden. An der Scheibe 51 ist ein Haken 57 angeordnet, damit über ein Seil 58 die Vorrichtung durch das Rohr gezogen werden kann. Die Dichtungen 53 und 54 in Verbindung mit der Rohrwandung bilden den geschlossenen Vakuum-Behälter.

Figur 8 zeigt die Lösung, daß der Vakuum-Behälter 10 aus einem zylindrischen Behälter 59 und Boden 60 besteht, der durch den Deckel 61 verschließbar ist. Die Kathode 17 mit dem Schutzschild 20 ist am Boden 60 befestigt. Die Anode 21, ebenfalls von einem Schutzschild 62 umgeben, ist am Deckel 61 befestigt. Dadurch kann der zu verdampfende nachschiebbare Teil 25 der Anode leicht von oben nachgeschoben werden. Die zu bedampfenden Objekte 37, 37a usw. sind an einem Einsatz 63 vorhanden, der in den Behälter einsetzbar ist.

Eine vergleichbare Lösung ist in Figur 10 dargestellt. Bei dieser Lösung ist die Anode 21 am Boden 60 befestigt. Die zu bedampfenden Objekte 37, 37a usw. sind an dem Korb 63 angeordnet. Dieser besteht beispielsweise aus Kunststoff und somit einem Material, das nach gewisser Zeit weggeworfen werden kann. Diese Lösung gewährleistet, daß der Vakuum-Behälter 10 nicht oder nur sehr wenig innen mit einer von dem zu verdampfenden Material herrührenden Schicht belegt wird.

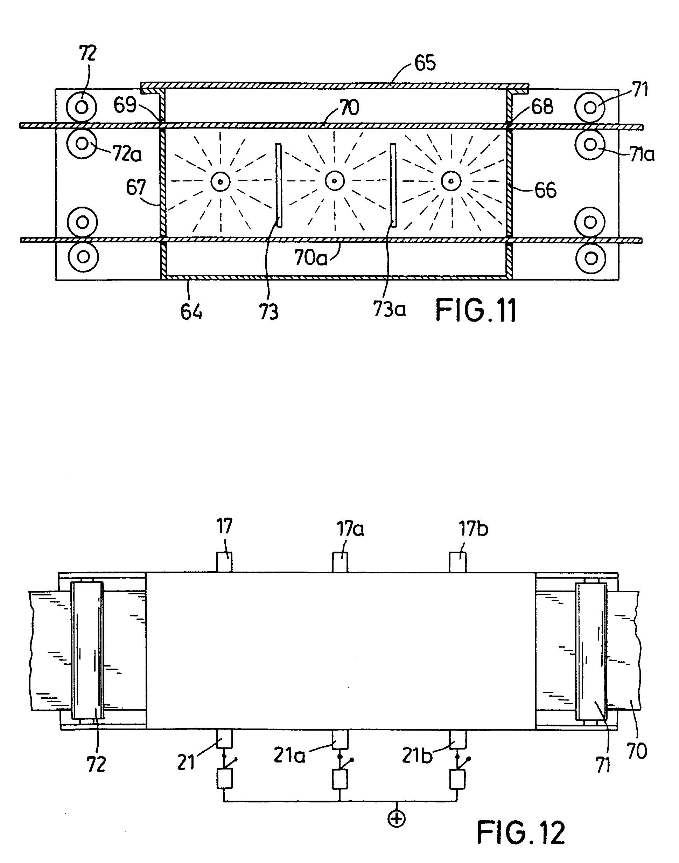

Figur 11 zeigt die Lösung, die zur Beschichtung für Folien aus Metall oder Kunststoff geeignet ist. In einem im Querschnitt rechteckigen Behälter 64 mit dem Deckel 65 sind in den Seitenwandungen gegenüberliegend die Elektroden 17, 17a, 17b mit den Anoden 21, 21a, 21b vorhanden. Die querverlaufenden Wandungen 66 und 67 haben den Folieneingang 68 und Ausgang 69 für die zu beschichtende Folie 70, die durch zugeordnete Vorzugswalzen 71, 71a bzw. Abzugswalzen 72, 72a bewegt wird. Mit 73, 73a sind Trennwände dargestellt. Figur 11 zeigt, daß zugleich eine weitere Folienbahn 70a behandelt werden kann. Die Strahlrichtung der Dampfpartikel ist in gestrichelter Linie angegeben.

Figur 12 zeigt schematisch, daß gleichzeitig alle oder wahlweise einzelne Elektrodenpaare zur Verdampfung des anodischen Materials, gegebenenfalls aus unterschiedlichen Materialien, betätigt sein können

## Patentansprüche

1. Verfahren zur Materialbeschichtung, wobei das zu beschichtende Material in einer Unterdruckkammer Materialdampf ausgesetzt wird, der durch Beschuß des zu verdampfenden Materials mit Elektronen aus einer zwischen einer Kathode und einer Anode brennenden Bogenentladung erzeugt wird, wobei Kathode und Anode in der Unterdruckkammer angeordnet sind und das zu verdampfende Material mit der Anode verbunden ist dadurch gekennzeichnet, daß
a) die Elektronen zum Erhalt einer Vakuumbogenentladung zwischen der Kathode und der Anode in den Kathodenflecken auf der Oberfläche besagter Kathode entstehen,
b) die in dieser Vakuumbogenentladung erzeugten Elektronen die Anode oder einen Teil derselben so stark verdampfen, daß die Vakuumbogenentladung im wesentlichen durch das verdampfte Anodenmaterial als Brennmedium aufrechterhalten wird,
c) die in besagter Vakuumbogenentladung erzeugten Elektronen sich selbsttätig ohne Anwendung äußerer Magnetfelder auf der Anode fokussieren.

2. Verfahren nach Anspruch 1, dadurch gekennzeichnet, daß der Anode während des Betriebes verdampfbares Material zugeführt wird.

3. Verfahren nach Anspruch 1, dadurch gekennzeichnet, daß während der Verdampfung die Verdampfungsrate durch Veränderung der Stromstärke variiert wird.

4. Verfahren nach Anspruch 1, dadurch gekennzeichnet, daß gleichzeitig aus mehreren Verdampfungsquellen unter gleichen oder unterschiedlichen elektrischen Bedingungen verdampft wird.

5. Verfahren nach Anspruch 1, dadurch gekennzeichnet, daß nacheinander aus mehreren Verdampfungsquellen unter gleichen oder unterschiedlichen elektrischen Bedingungen verdampft wird.

6. Verfahren nach Anspruch 1, dadurch gekennzeichnet, daß die Anode und Kathode gegenüber dem Vakuumgefäß auf unterschiedliches und veränderbares elektrisches Potential gebracht werden.

7. Verfahren nach Anspruch 1, dadurch gekennzeichnet, daß die zu bedampfenden Substrate auf veränderbarem elektrischen Potential gegenüber dem Vakuumgefäß und den Elektroden gehalten werden.

8. Verfahren nach den Ansprüchen 1 und 5, dadurch gekennzeichnet, daß während der Verdampfung die Anode bzw. Anoden relativ zur Kathode bzw. dem Vakuumgefäß bewegt werden.

9. Verfahren nach den Ansprüchen 1, 5 und 6, dadurch gekennzeichnet, daß während des Aufdampfungvorganges Eine diesen Aufdampfungsvorgang beeinflussende reaktive Gasatmosphäre im Aufdampfraum aufrechterhalten wird.

10. Verfahren nach den Ansprüchen 1, 5 und 6, dadurch gekennzeichnet, daß die zu bedampfenden Objekte bzw. Substrate während des Aufdampfvorganges als Kathode einer unabhängigen Entladung geschaltet werden.

11. Verfahren nach den Ansprüchen 1, 5 und 6, dadurch gekennzeichnet, daß Nichtleiter im Kontakt mit der Anode verdampft werden.

12. Verfahren nach Anspruch 1, dadurch gekennzeichnet, daß zum sicheren Einleiten der anodischen Verdampfung dem Versorgungsstrom ein Stromimpuls von mindestens 100 A überlagert wird.

13. Verfahren nach den Ansprüchen 1 bis 12, dadurch gekennzeichnet, daß innerhalb der Unterdruckkammer (11) ein Unterdruck von mindestens 10⁻¹ Pa, vorzugsweise von 10⁻¹ bis 10⁻² Pa vorhanden ist.

14. Verfahren nach den Ansprüchen 1 bis 12, dadurch gekennzeichnet, daß jede der beiden Elektroden (17, 21) an einen Strom von mindestens 10 bis 40 A und eine Spannung von 35 Volt angeschlossen ist.

15. Verfahren nach den Ansprüchen 1 bis 14, dadurch gekennzeichnet, daß der Objekthalter (36) und damit das zu bedampfende Objekt (37) während der Bedampfung rotieren.

16. Vorrichtung zur Bedampfung eines Objektes in einem Stahlzylinder (11) mit Boden (12) und Deckel (13), wobei der Behälter über einen Ausgang (15) an eine Vakuumpumpe angeschlossen ist, über eine Zündeinrichtung verfügt und in dem Behälter gegenüberliegend eine stromführende kalte Kathode (17) und eine stromführende kalte hohl ausgebildete Anode (21) angeordnet sind, wobei die Anode mit dem zu verdampfenden Material belegt wird und das zu bedampfende Objekt (37) innerhalb des Behälters im Bereich der Anode (21) und im Bereich der Kathode (17) angeordnet ist, dadurch gekennzeichnet, daß
a) der in den Behälter hineinragende Teil der Kathode (17) von einem Schutzschild (20) umgeben ist, das an der Behälterwandung (11 a) angeordnet ist;
b) daß die Kathode (17) hohl ausgebildet ist und an ihrem stirnseitigen Ende über ein angeschraubtes Kathodenteil (17) verfügt mit einer Stirnfläche (30), die der Anode zugewandt ist;
c) daß die Kathode mit einer zugeordneten Kühlmittelzuflußleitung und Abflußleitung versehen ist, so daß die Stirnfläche ausreichend gekühlt werden kann.

17. Vorrichtung nach Anspruch 16, dadurch gekennzeichnet, daß die Kathode (17) und/oder die Anode (21) relativ zueinander verschiebbar gelagert sind.

18. Vorrichtung nach Anspruch 16, dadurch gekennzeichnet, daß zur Zündung des Bogens in dem Bereich zwischen Anode und Kathode eine Vorrichtung (31 bis 34) zur Zündung durch Plasmabeschuß (Gleitfunken) angeordnet ist.

19. Vorrichtung nach Anspruch 16, dadurch gekennzeichnet, daß sich in der Unterdruckkammer eine Einrichtung zur Aufnahme der zu bedampfenden Objekte befindet.

20. Vorrichtung nach Anspruch 16, dadurch gekennzeichnet, daß die durch ein Kühlmittel gekühlte Anode (21) an ihrem zur Kathode (17) weisenden Ende mit einer Verlängerung (45, 45a, 46, 27) aus einem hochschmelzenden Material versehen ist, das mit dem zu verdampfenden Material (25) belegt ist.

21. Vorrichtung nach Anspruch 20, dadurch gekennzeichnet, daß das zu verdampfende Material (25) nachschiebbar ist.

22. Vorrichtung nach Anspruch 21, dadurch gekennzeichnet, daß innerhalb der gekühlten Anode (21) ein Hohlstab (27) angeordnet ist, in dem das zu verdampfende, in Achsrichtung nachschiebbare Material (29) angeordnet ist.

23. Vorrichtung nach Anspruch 16, dadurch gekennzeichnet, daß der Raum zwischen der Anordnung des zu bedampfenden Objektes und den die Bedampfung herbeiführenden Elektroden durch eine bewegliche Wandung (35) absperrbar ist.

24. Vorrichtung nach Anspruch 16, dadurch gekennzeichnet, daß im Bereich des zu bedampfenden Objektes (37) in der Wandung des Vakuumbehälters gegenüberliegende Elektroden (38, 39) für eine Glimmentladung vorhanden sind.

25. Vorrichtung nach Anspruch 16, dadurch gekennzeichnet, daß der Objekthalter (36) und damit das zu bedampfende Objekt (37) an eine Minus-Leitung angeschlossen sind.

26. Vorrichtung nach Anspruch 16, dadurch gekennzeichnet, daß zwei miteinander verbundene Ringscheiben (51, 52) vorhanden sind, die an ihrem Außenumfang mit einer umlaufenden Abdichtung (53, 54) versehen sind und an der Innenwandung der einen Scheibe die Kathode (17) und an der gegenüberliegenden Innenwandung der anderen Scheibe die Anode (21) vorhanden ist, weiterhin eine Scheibe (52), die mit einem Schlauch (56) für Unterdruck und dem elektrischen Kabel (55) zur Stromversorgung der beiden Elektroden (17, 21) versehen ist.

27. Vorrichtung nach Anspruch 16, dadurch gekennzeichnet, daß bei einem zylindrischen Behälter die koaxial gegenüberliegenden Elektroden (17, 21) im Boden (60) und Deckel (61) angeordnet sind.

28. Vorrichtung nach Anspruch 27, dadurch gekennzeichnet, daß in dem Vakuumbehälter (11) ein herausnehmbarer Einsatz (63) vorhanden ist, an dessen ringsumlaufenden inneren Flächen die zu bedampfenden Objekte (37, 37a usw.) angeordnet sind.

29. Vorrichtung nach Anspruch 16, dadurch gekennzeichnet, daß in dem Vakuumbehälter mehrere Anoden (21, 21a) angeordnet sind.

30. Vorrichtung nach Anspruch 16, dadurch gekennzeichnet, daß in dem Vakuumbehälter mehrere Kathoden angeordnet sind.

31. Vorrichtung nach Anspruch 16, dadurch gekennzeichnet, daß in einem Vakuumbehälter von im Querschnitt rechteckiger Ausbildung in der einen Seitenwandung die Kathode (17) und in der anderen Seitenwandung die Anode (21) angeordnet ist und in der einen Stirnwandung (66) der Eingang und in der gegenüberliegenden anderen Stirnwandung (67) der Ausgang der durch Bedampfung zu beschichtenden Folie (70) angeordnet ist.

32. Vorrichtung nach Anspruch 31, dadurch gekennzeichnet, daß eine zu bedampfende Folie (70) oberhalb und eine andere zu bedampfende Folie (70a) unterhalb der Elektroden (17, 21) angeordnet sind.

33. Vorrichtung nach den Ansprüchen 31 und 32, dadurch gekennzeichnet, daß in Bewegungsrichtung der Folienbahn (70) oder der Folienbahnen (70, 70a) hintereinander mehrere Elektrodenpaare (17, 21 und 17a und 21a) angeordnet sind.

## Claims

1. A process for coating material, the material to be coated being exposed in a vacuum chamber to material vapour generated by bombarding the material to be evaporated with electrons from an arc discharge burning between a cathode and an anode, cathode and anode being located in said vacuum chamber and the material to be evaporated being connected with the anode, characterized in that
a) the electrons for maintaining a vacuum arc discharge between cathode and anode are generated within the cathode spots on the surface of said cathode,
b) the electrons generated within this vacuum arc discharge evaporate the anode or part thereof to such high an amount that the vacuum arc discharge substantially is maintained by the evaporated anode material as the arc medium,
c) the electrons generated in said vacuum arc discharge autofocus on the anode without application of external magnetic fields.

2. The process according to claim 1, characterized in that during operation the anode is fed with evaporable material.

3. The process according to claim 1, characterized in that during evaporation the evaporation rate is varied by variation of current intensity.

4. The process according to claim 1, characterized in that evaporation is effected simultaneously from several evaporation sources under equal or different electrical conditions.

5. The process according to claim 1, characterized in that evaporation is effected succesively from several evaporation sources under equal or different electrical conditions.

6. The process according to claim 1, characterized in that anode and cathode are set to different and variable electrical potential with respect to the vacuum container.

7. The process, according to claim 1, characterized in that the substrates to be coated by evaporation are maintained at variable electrical potential with respect to vacuum container and electrodes.

8. Process according to claims 1 and 5, characterized in that during evaporation the anode or anodes are moved relative to cathode or vacuum container.

9. Process according to claims 1, 5, and 6, characterized in that during the evaporation procedure a reactive gas atmosphere is maintained within the vapour-deposit chamber which influences said evaporation procedure.

10. Process according to claims 1, 5, and 6, characterized in that the objects or substrates to be coated by evaporation are connected as the cathode of an independent discharge during the evaporation procedure.

11. Process according to claims 1, 5, and 6, characterized in that non-conductors in contact with the anode are evaporated.

12. The process according to claim 1, characterized in that the supply current is superposed by a current pulse of at least 100 A for safe initiation of the anodic evaporation.

13. Process according to claims 1 to 12, characterized in that within the vacuum chamber (11) a vacuum of at least 10⁻¹ Pa, preferably of from 10⁻¹ to 10⁻², is present.

14. Process according to claims 1 to 12, characterized in that each of the two electrodes (17, 21) is connected to a current of at least 10 to 40 A and a voltage of 35 V.

15. Process according to claims 1 to 14, characterized in that object holder (36) and thus, the object to be coated by evaporation (37) are rotated during vapour-depositing.

16. A device for coating an object by evaporation in a steel cylinder (11) having bottom (12) and cap (13), the container being connected via an outlet (15) to a vacuum pump and provided with an ignition unit, and in the container, opposed to each other, a current-carrying cold cathode (17) and a current-carrying cold hollow-formed anode (21) are arranged, the anode being covered with the material to be evaporated, and the object to be coated by evaporation (37) being arranged within the container in the zone of the anode (21) and in the zone of the cathode (17), characterized in that
a) the part of the cathode (17) projecting into the container is surrounded by a protective shield (20) being arranged at the container wall (11a);
b) the cathode (17) is hollow-formed and provided at its front end with a screw-connected cathode part (17) having a front surface (30) which is directed towards the anode;
c) the cathode is provided with a related coolant feed line and outflow line such that the front surface can be cooled sufficiently.

17. The device according to claim 16, characterized in that cathode (17) and/or anode (21) can be shifted in their bearings relative to each other.

18. The device according to claim 16, characterized in that within the zone between anode and cathode a device (31 to 34) for ignition by plasma bombardment (creepage spark) is arranged to ignite the arc.

19. The device according to claim 16, characterized in that the vacuum chamber is provided with a unit to accomodate the objects to be coated by evaporation.

20. The device according to claim 16, characterized in that the anode (21) cooled by a coolant is provided at its end pointing towards the cathode (17) with an extension (45, 45a, 46, 47) of refractory material being covered with the material to be evaporated (25).

21. The device according to claim 20, characterized in that the material to be evaporated (25) is feedable by pushing.

22. The device according to claim 21, characterized in that within the cooled anode (21) a hollow rod (27) is arranged wherein the material to be evaporated and push-feedable in axis direction (29) is arranged.

23. The device according to claim 16, characterized in that the space between arrangement of the object to be coated by evaporation and the electrodes effecting vapour-deposition may be shut off by a movable wall (35).

24. The device according to claim 16, characterized in that within the zone of the object to be coated by evaporation (37), electrodes (38, 39) for a glow discharge are present opposite each other in the wall of the vacuum container.

25. The device according to claim 16, characterized in that the object holder (36) and the object to be coated by evaporation (37) are connected to a negative line.

26. The device according to claim 16, characterized in that two interconnected ring disks (51, 52) are present, provided with a gasket (53, 54) leading around their outer perimeter, and at the inner wall of the one disk the cathode (17), and at the opposite inner wall of the other disk the anode (21) is present, and additionally, a disk (52) provided with a tubing (56) for vacuum and the electric cable for current supply of both electrodes (17, 21).

27. The device according to claim 16, characterized in that with a cylindric container, the coaxially opposed electrodes (17, 21) are arranged in bottom (60) and cap (61).

28. The device according to claim 27, characterized in that in the vacuum container (11), a removable insert (63) is present, at the inner surface of which leading around in a circle, the objects to be coated by evaporation (37, 37a, etc.) are arranged.

29. The device according to claim 16, characterized in that several anodes (21, 21a) are arranged in the vacuum container.

30. The device according to claim 16, characterized in that several cathodes are arranged in the vacuum container.

31. The device according to claim 16, characterized in that in a vacuum container formed with rectangular cross-section, the cathode (17) is arranged in one side wall and in the other side wall the anode (21), and in one front wall (66) the input, and in the opposite other front wall (67) the output of the film (70) to be coated by evaporation is arranged.

32. The device according to claim 31, characterized in that one film (70) to be coated by evaporation is arranged above and another film (70a) to be coated by evaporation is arranged below the electrodes (17, 21).

33. Device according to claims 31 and 32, characterized in that in direction of movement of the film web (70) or the film webs (70, 70a), several electrode pairs (17, 21 and 17a and 21a) are arranged in succession.

## Revendications

1. Procédé de revêtement d'un matériau, dans lequel le matériau à revêtir est exposé dans une enceinte sous vide à une vapeur de matière qui est produite par bombardement de la matière à vaporiser par des électrons issus d'une décharge d'arc brûlant entre une cathode et une anode, la cathode et l'anode étant placées dans l'enceinte sous vide et la matière à vaporiser étant reliée à l'anode, le procédé étant caractérisé en ce que :
a) pour maintenir une décharge d'arc sous vide entre la cathode et l'anode, les électrons sont formés dans les taches cathodiques à la surface de la cathode susmentionnée,
b) les électrons produits dans cette décharge d'arc sous vide vaporisent l'anode, ou une partie de celle-ci, assez fortement pour que la décharge d'arc sous vide soit entretenue essentiellement par la matière anodique vaporisée comme agent de combustion, et
c) les électrons produits dans la décharge d'arc sous vide précitée se focalisent automatiquement sur l'anode sans utilisation de champ magnétique externe.

2. Procédé selon la revendication 1, caractérisé en ce qu'une matière vaporisable est acheminée à l'anode au cours de l'exploitation.

3. Procédé selon la revendication 1, caractérisé en ce que, au cours de la vaporisation, on modifie le taux de vaporisation par variation de l'intensité du courant.

4. Procédé selon la revendication 1, caractérisé en ce que la vaporisation se fait simultanément à partir de plusieurs sources de vaporisation dans des conditions électriques identiques ou différentes.

5. Procédé selon la revendication 1, caractérisé en ce que la vaporisation se fait successivement à partir de plusieurs sources de vaporisation dans des conditions électriques identiques ou différentes.

6. Procédé selon la revendication 1, caractérisé en ce que l'anode et la cathode sont portées à un potentiel électrique différent et modifiable vis-à-vis de l'enceinte sous vide.

7. Procédé selon la revendication 1, caractérisé en ce que les substrats à revêtir sont maintenus sous un potentiel électrique modifiable vis-à-vis de l'enceinte sous vide et des électrodes.

8. Procédé selon les revendications 1 et 5, caractérisé en ce que, au cours de la vaporisation, on déplace l'anode ou les anodes par rapport à la cathode et/ou à l'enceinte sous vide.

9. Procédé selon les revendications 1, 5 et 6,caractérisé en ce que, au cours de l'opération de vaporisation, on maintient dans l'enceinte de vaporisation une atmosphère de gaz réactive qui influence cette opération de vaporisation.

10. Procédé selon les revendications 1, 5 et 6, caractérisé en ce que les objets ou les substrats à revêtir sont connectés de façon à constituer la cathode d'une décharge autonome au cours de l'opération de vaporisation.

11. Procédé selon les revendications 1, 5 et 6, caractérisé en ce que des corps non conducteurs sont vaporisés en contact avec l'anode.

12. Procédé selon la revendication 1, caractérisé en ce que, pour réaliser de façon sûre l'amorçage de la vaporisation anodique, on superpose au courant d'alimentation une impulsion de courant d'au moins 100 A.

13. Procédé selon les revendications 1 à 12, caractérisé en ce que l'intérieur de l'enceinte sous vide (11) est soumise à un vide d'au moins 10⁻¹ Pa, de préférence de 10⁻¹ à 10⁻² Pa.

14. Procédé selon les revendications 1 à 12, caractérisé en ce que chacune des deux électrodes (17, 21) est connectée à un courant d'au moins 10 à 40 A et à une tension de 35 V.

15. Procédé selon les revendications 1 à 14, caractérisé en ce que le porte-objet (36) et donc l'objet à revêtir (37) tournent au cours de la vaporisation.

16. Dispositif de vaporisation d'un objet dans un cylindre d'acier (11) avec un fond (12) et un couvercle (13), dispositif dans lequel l'enceinte est raccordée par une sortie (15) à une pompe à vide et comprend un dispositif d'amorçage tandis qu'une cathode froide conductrice (17) et une anode creuse froide conductrice (21) sont agencées en regard dans l'enceinte, l'anode étant garnie de la matière à vaporiser et l'objet à revêtir (37) étant placé à l'intérieur de l'enceinte dans la région de l'anode (21) et dans la région de la cathode (17), le dispositif étant caractérisé en ce que:
a) la partie de la cathode (17) faisant saillie dans l'enceinte est entourée d'un écran de protection (20) qui est monté sur la paroi (11 a) de l'enceinte;
b) la cathode (17) est conformée en creux et porte, à son extrémité frontale, une pièce cathodique (17) vissée, avec une surface frontale (30) tournée vers l'anode;
c) la cathode est dotée d'une conduite d'alimentation et d'une conduite d'évacuation d'agent de refroidissement, de telle sorte que la surface frontale peut être suffisamment refroidie.

17. Dispositif selon la revendication 16, caractérisé en ce que la cathode (17) et/ou l'anode (21) sont montées de façon à pouvoir se déplacer l'une par rapport à l'autre.

18. Dispositif selon la revendication 16, caractérisé en ce que, pour amorcer l'arc, un dispositif (31 à 34) est disposé dans la région comprise entre la cathode et l'anode, en vue d'un amorçage par bombardement de plasma (étincelles glissantes).

19. Dispositif selon la revendication 16, caractérisé en ce qu'un dispositif de réception des objets à revêtir se trouve dans l'enceinte sous vide.

20. Dispositif selon la revendication 16, caractérisé en ce que l'anode (21) refroidie par un agent de refroidissement, est pourvue, sur son extrémité tournée vers la cathode (17), d'un prolongement (45, 45a, 46, 27) d'une matière à haut point de fusion, qui est garni de la matière à vaporiser (25).

21. Dispositif selon la revendication 20, caractérisé en ce que la matière à vaporiser (25) peut être refoulée dans l'enceinte.

22. Dispositif selon la revendication 21, caractérisé en ce qu'à l'intérieur de l'anode refroidie (21) est agencée une tige creuse (27) dans laquelle est disposée la matière à vaporiser (29) qui peut être refoulée axialement.

23. Dispositif selon la revendication 16, caractérisé en ce que l'espace compris entre l'agencement de l'objet à revêtir et les électrodes provoquant la vaporisation peut être obturé par une paroi mobile (35).

24. Dispositif selon la revendication 16, caractérisé en ce que des électrodes (38, 39) en regard l'une de l'autre dans la région de l'objet à revêtir (36), placées dans la paroi de l'enceinte sous vide, sont prévues pour une effluve électrique.

25. Dispositif selon la revendication 16, caractérisé en ce que le porte-objet (36) et donc l'objet à revêtir (37) sont raccordés à un conducteur négatif.

26. Dispositif selon la revendication 16, caractérisé en ce qu'il est prévu deux disques annulaires (51, 52) reliés l'un à l'autre, qui portent sur leur contour externe une garniture d'étanchéité périphérique (53, 54), la cathode (17) étant montée sur la paroi interne du premier disque tandis que l'anode (21) est agencée sur la paroi interne en regard de l'autre disque, un des disques (52) par ailleurs équipé d'un tuyau flexible (56) pour appliquer le vide et du câble électrique (55) d'alimentation en courant des deux électrodes (17, 21).

27. Dispositif selon la revendication 16, caractérisé en ce que, dans une enceinte cylindrique, les électrodes coaxialement en regard l'une de l'autre (17, 21) sont montées dans le fond (60) et dans le couvercle (61).

28. Dispositif selon la revendication 27, caractérisé en ce qu'il est prévu dans l'enceinte sous vide (11) une pièce rapportée amovible (63) sur les surfaces annulaire périphériques internes desquelles sont montés les objets à revêtir (37, 37a etc.).

29. Dispositif selon la revendication 16, caractérisé en ce que plusieurs anodes (21, 21a) sont agencées dans l'enceinte sous vide.

30. Dispositif selon la revendication 16, caractérisé en ce que plusieurs cathodes sont agencées dans l'enceinte sous vide.

31. Dispositif selon la revendication 16, caractérisé en ce que, dans une enceinte sous vide de conformation rectangulaire en coupe transversale, la cathode (17) est montée dans une paroi latérale tandis que l'anode (21) est montée dans l'autre paroi latérale, et dans la première paroi frontale (66) est prévue l'entrée, et dans l'autre paroi frontale en regard (67), la sortie, de la feuille à revêtir par vaporisation (70).

32. Dispositif selon la revendication 31, caractérisé en ce qu'une feuille à revêtir (70) est agencée au-dessus des électrodes (17, 21) tandis qu'une autre feuille à revêtir (70a) est disposée au-dessous de ces électrodes.

33. Dispositif selon les revendications 31 et 32, caractérisé en ce que plusieurs paires d'électrodes (17, 21 et 17a, 21a) situées l'une derrière l'autre sont disposées dans la direction de mouvement de la feuille (70) ou des feuilles (70, 70a).
